# EUROPEAN PATENT APPLICATION

(11) **EP 4 813 920 A1**
(43) Date of publication of application: **30.09.2026**
(21) Application number: 24893809.4
(22) Date of filing: 30.07.2024
(51) Int. Cl.: C01G 15/00, C09K 11/62

(54) **CRYSTAL BODY, PHOSPHOR, FLUORESCENT MATERIAL, AND RESIN SHEET**

(30) Priority: 21.11.2023 JP 2023197734
(71) Applicant: Fuso Chemical Co., Ltd., Osaka-shi, Osaka 541-0041 (JP)
(72) Inventor: NASUDA, Yuko, Osaka-shi, Osaka 541-0041 (JP); OKURA, Hiroshi, Osaka-shi, Osaka 541-0041 (JP); SHIMIZU, Kohei, Osaka-shi, Osaka 541-0041 (JP); TODA, Kenji, Niigata-shi, Niigata 950-2181 (JP); HIKITA, Wataru, Niigata-shi, Niigata 950-2181 (JP)
(74) Representative: Müller-Boré & Partner Patentanwälte PartG mbB
(86) International application number: PCT/JP2024/027172
(87) International publication number: WO 2025/109814

(57) **Abstract**

Provided is a crystal body having an oxide matrix composed of SrCa₂Ga₂O₆ or BaSr₂Ca₆Ga₆O₁₈. The present invention can provide a crystal body that is composed of relatively inexpensive and stably available components and can be used as a phosphor having excellent characteristics.

## Description

### TECHNICAL FIELD

The present invention relates to a crystal body, a phosphor, a fluorescent material, and a resin sheet.

### BACKGROUND ART

In white LEDs in general, a yellow phosphor (or a green phosphor and a red phosphor) is placed on a blue LED chip, excited by the light of the blue LED (around λ = 460 nm) to emit yellow light, and combined with the blue light of the blue LED itself to obtain white light by mixing colors (refer to Patent Literature 1, for example).

In particular, phosphors that exhibit narrow-band green emission and narrow-band red emission are required in backlights for liquid crystal displays and the like, which must include the three primary colors of light.

Most of the current phosphors are manufactured by doping oxides, nitrides, and fluorides as matrices with rare earths as rare metals or transition metal ions as luminescent ions.

This leads to an increase in the cost of phosphors, which is undesirable also from such a viewpoint as a reduction in the amount of rare metals used.

In recent years in particular, infrared light-emitting materials that absorb light in the ultraviolet to visible light region and emit light in the infrared region have been attracting increasing attention. For example, applications in devices such as the following are possible.

First, in silicon solar cells, improvements have been made over the years, but it still takes multiple years to improve their efficiency by just 0.1%. Wavelength conversion film technology for solar cells is attracting attention as a solution to this problem. This technology can easily improve the efficiency of solar cells by converting ultraviolet to blue light, which cannot be absorbed by solar cells, into wavelengths that can be absorbed by solar cells. In particular, materials that can be converted to the infrared region with high efficiency have not yet been found, and there is a strong need for their development.

Organic high conversion efficiency materials are also used in the technology of adding wavelength conversion materials to polymer sheets for agricultural greenhouses and tunnels to promote plant growth, but their use is limited by their low weather resistance and short Stokes shift, which causes them to absorb much light in the visible light region. Meanwhile, infrared light-emitting inorganic wavelength conversion materials have significant advantages over organics in terms of stability, but no highly efficient ones have been found to date.

In the field of security technology, security inks that emit visible light when irradiated with ultraviolet light have been used in the past, but there is a need for technology with even higher security performance in the future. Security inks that absorb visible light and convert it to near-infrared light are considered to have higher security performance than conventional products because of their invisible properties, and the development of more efficient materials is expected.

In addition, applications to medical technologies such as skin condition improvement, displays, and various LEDs are expected, and interest in highly efficient infrared light-emitting materials is growing.

It has been reported that rare earth elements (Pr³⁺, Nd³⁺, Tm³⁺, Eu²⁺, and the like) or transition metal elements (Cr³⁺, Ni²⁺, V²⁺, Mn⁴⁺, and the like) are used as the luminescent center of near-infrared light in phosphor materials (Non-Patent Literature 1 and 2).

### CITATION LIST

### PATENT LITERATURE

Patent Literature 1: Japanese Patent Publication 2007-326981-A

### NON PATENT LITERATURE

Non Patent Literature 1: F. A. Kroger, Some Aspects of the Luminescence of Solids. (1948)
Non Patent Literature 2: Toda K., Sato M., Chem Lett. 2014; 43(8)

### SUMMARY OF INVENTION

### Technical Problem

In order for crystal bodies to be widely used in various applications, including phosphor applications, there is a need to develop crystal bodies having novel structures that are composed of relatively inexpensive and stably available components and exhibit new properties.

In addition, phosphor applications require crystal bodies that are composed of relatively inexpensive and stably available components and emit light in the visible to infrared light region with high efficiency.

Thus, an object of the present invention is to solve at least one of the following.

An object of the present invention is to provide a crystal body having a novel structure composed of relatively inexpensive and stably available components.

An object of the present invention is to provide a crystal body that is composed of relatively inexpensive and stably available components and can be used as a phosphor having excellent characteristics.

### Solution to Problem

These objects are achieved by the following present invention.

The crystal body of the present invention has an oxide matrix composed of SrCa₂Ga₂O₆.

The crystal body of the present invention only needs to have the oxide matrix composed of SrCa₂Ga₂O₆ and may contain elements different from the elements constituting the oxide matrix, and the characteristics of the crystal body can be suitably adjusted by the kind, the content, and the like of such elements.

As described above, the crystal body of the present invention may contain elements other than the elements constituting the oxide matrix (that is, Sr, Ca, Ga, and O) (hereinafter also referred to as "another element").

For example, for at least one of Sr sites, Ca sites, and Ga sites constituting the oxide matrix, at least some of the atoms constituting the sites may be substituted by another element.

However, the content of the other element in the crystal body of the present invention is preferably 5% by mass or less, more preferably 0.01% by mass or more and 4% by mass or less, and even more preferably 0.1% by mass or more and 3% by mass or less.

In particular, part of Ga constituting the oxide matrix is preferably substituted by another element. This allows a crystal body having a crystal structure of the oxide matrix to be produced more suitably.

Examples of the other element include Mn, Cr, Fe, Bi, Ti, V, and rare earth elements (Sc, Y, La, Ce, Pr, Nd, Pm, Sm, Eu, Gd, Tb, Dy, Ho, Er, Tm, Yb, and Lu), and one or more selected from these can be used, but they are preferably one or more selected from the group consisting of Mn, Cr, Bi, and rare earth elements, more preferably one or more selected from the group consisting of Mn and Cr, and even more preferably Mn. This produces a crystal body that emits light upon excitation with near-ultraviolet to blue light.

In the crystal body of the present invention, part of Ga constituting the oxide matrix is preferably substituted by another element.

In the crystal body of the present invention, the other element is preferably one or more selected from the group consisting of Mn, Cr, Fe, Ti, Bi, and rare earth elements.

In the crystal body of the present invention, a substitution ratio of the Ga by the other element is preferably 0.10 or less in terms of molar ratio.

The crystal body of the present invention is preferably represented by Formula (1) below:

SrCa₂(Ga₍₁₋ₓ₎Mₓ)₂O₆ (1)

in Formula (1), M is one or more selected from the group consisting of Mn, Cr, Fe, Ti, Bi, and rare earth elements; and the relation 0 < x ≤ 0.10 is satisfied.

The crystal body of the present invention has an oxide matrix composed of BaSr₂Ca₆Ga₆O₁₈.

In the crystal body of the present invention, part of Ga constituting the oxide matrix is preferably substituted by another element.

In the crystal body of the present invention, the other element substituting the Ga is preferably one or more selected from the group consisting of Mn, Cr, Fe, Ti, Bi, and rare earth elements.

In the crystal body of the present invention, a substitution ratio of the Ga by the other element is preferably 0.10 or less, in terms of molar ratio.

The crystal body of the present invention is preferably represented by Formula (2) below:

BaSr₂Ca₆(Ga₍₁₋ₓ₎Mₓ)₆O₁₈ (2)

in Formula (2), M is one or more selected from the group consisting of Mn, Cr, Fe, Ti, Bi, and rare earth elements; and the relation 0 < x ≤ 0.10 is satisfied.

The phosphor of the present invention contains the crystal body of the present invention.

The fluorescent material of the present invention is the phosphor of the present invention surface-coated with a light transmissive resin.

The resin sheet of the present invention contains a light transmissive resin base material, and includes the phosphor of the present invention.

### Advantageous Effect of Invention

The present invention can provide a crystal body having a novel structure composed of relatively inexpensive and stably available components.

The present invention can provide a crystal body that is composed of relatively inexpensive and stably available components and can be used as a phosphor having excellent characteristics.

### BRIEF DESCRIPTION OF DRAWINGS

FIG. 1 is a flowchart of an example of steps of a method for producing a crystal body of the present invention.
FIG. 2 is a diagram of an X-ray diffraction pattern of a crystal body of Example 1.
FIG. 3 is a diagram of powder X-ray diffraction patterns of crystal bodies of Examples 2 to 10.
FIG. 4 is a diagram of measurement results of photoluminescence for the crystal body of Example 1.
FIG. 5 is a diagram of measurement results of photoluminescence for the crystal body of Example 1.
FIG. 6 is a diagram of the relation of emission intensity when crystal bodies of Examples 2 to 9 are irradiated with ultraviolet light (365 nm) at a certain intensity.
FIG. 7 is a diagram of photographs of the crystal body of Example 1 when irradiated with room light, when irradiated with ultraviolet light having a wavelength of 254 nm, and when irradiated with ultraviolet light having a wavelength of 365 nm.
FIG. 8 is a diagram of a powder X-ray diffraction pattern of a crystal body of Example 11.
FIG. 9 is a diagram of measurement results of photoluminescence for the crystal body of Example 11.
FIG. 10 is a schematic diagram of a crystal body having an oxide matrix composed of BaSr₂Ca₆Ga₆O₁₈ according to a second aspect of the present invention.
FIG. 11 is a diagram of powder X-ray diffraction patterns of crystal bodies of Examples 12 to 18.
FIG. 12 is a diagram of measurement results of photoluminescence for the crystal bodies of Examples 12 to 18 when excited around 330 nm.

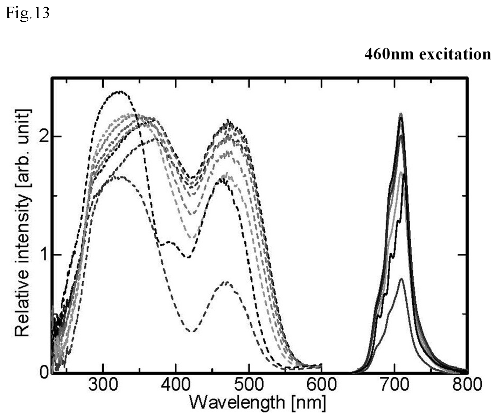

FIG. 13 is a diagram of measurement results of photoluminescence for the crystal bodies of Examples 12 to 18 when excited around 460 nm.

### DESCRIPTION OF EMBODIMENTS

Preferred embodiments of the present invention will be described below in detail.

### <Crystal Body of First Aspect of Present Invention>

### (1) Crystal Body

First, the crystal body of the present invention will be described.

In the following description, a case in which the crystal body of the present invention is an optical material, especially a phosphor, will be mainly described, but this is not limiting. The crystal body of the present invention can be applied as various optical materials other than the phosphor or materials other than optical materials in a wide range of applications as described below.

The crystal body of the present invention has an oxide matrix composed of SrCa₂Ga₂O₆.

This configuration can provide a crystal body that is composed of relatively inexpensive and stably available components and can be used as a phosphor having excellent characteristics. In particular, it has a novel crystal structure different from those of conventional crystal bodies, and provides fluorescence characteristics that cannot be obtained by compounds with known crystal structures, such as red emission on the longer wavelength side (emission on the longer wavelength side than 670 nm) and emission in a narrower band than those of compounds with conventional crystal structures. Therefore, the crystal body of the present invention can be suitably applied, for example, to phosphors for white LEDs, UV absorbers, phosphors for wavelength conversion films for silicon solar cells, wavelength conversion materials for agricultural sheets for plant growth control, security fields, biosensors, and the like. As will be described below in detail, the crystal body of the present invention only needs to have an oxide matrix composed of SrCa₂Ga₂O₆ and may contain elements different from the elements constituting the oxide matrix, and the characteristics of the crystal body can be suitably adjusted by the kind, the content, and the like of such elements.

As described above, the crystal body of the present invention may contain elements other than the elements constituting the oxide matrix (that is, Sr, Ca, Ga, and O) (hereinafter also referred to as "another element").

For example, for at least one of Sr sites, Ca sites, and Ga sites constituting the oxide matrix, at least some of the atoms constituting the sites may be substituted by another element.

However, the content of the other element in the crystal body of the present invention is preferably 5% by mass or less, more preferably 0.01% by mass or more and 4% by mass or less, and even more preferably 0.1% by mass or more and 3% by mass or less.

In particular, part of Ga constituting the oxide matrix is preferably substituted by another element. This allows a crystal body having a crystal structure of the oxide matrix to be produced more suitably.

Examples of the other element include Mn, Cr, Bi, Fe, Ti, V, and rare earth elements (Sc, Y, La, Ce, Pr, Nd, Pm, Sm, Eu, Gd, Tb, Dy, Ho, Er, Tm, Yb, and Lu), and one or more selected from these can be used, but they are preferably one or more selected from the group consisting of Mn, Cr, Bi, and rare earth elements, more preferably one or more selected from the group consisting of Mn and Cr, and even more preferably Mn. This produces a crystal body that emits light upon excitation with near-ultraviolet to blue light.

In the crystal body of the present invention, Mn is preferably contained in a tetravalent (Mn⁴⁺) state.

This produces a crystal body showing red emission with a peak at 712 nm by irradiation with near-ultraviolet to blue light.

The substitution ratio of the Ga by the other element is preferably 0.10 or less, more preferably 0.002 or more and 0.08 or less, and even more preferably 0.01 or more and 0.07 or less in terms of molar ratio.

This enables the crystal body to exhibit more excellent fluorescence characteristics (especially emission intensity).

In particular, the crystal body of the present invention is preferably represented by Formula (1) below:

SrCa₂(Ga₍₁₋ₓ₎Mₓ)₂O₆ (1)

in Formula (1), M is one or more selected from the group consisting of Mn, Cr, Fe, Ti, Bi, V, and rare earth elements; and the relation 0 < x ≤ 0.10 is satisfied.

This enables the crystal body to exhibit particularly excellent fluorescence characteristics (especially emission intensity).

x in Formula (1) above only needs to satisfy the relation 0 < x ≤ 0.10, but preferably satisfies the relation 0.001 ≤ x ≤ 0.09, more preferably satisfies the relation 0.002 ≤ x ≤ 0.08, and even more preferably satisfies the relation 0.01 ≤ x ≤ 0.07.

This allows the above-described effects to be exhibited more markedly.

M in Formula (1) above may be one or more selected from the group consisting of Mn, Cr, Fe, Ti, Bi, V, and rare earth elements, but is preferably one or more selected from the group consisting of Mn and Cr, and more preferably Mn.

This allows the above-described effects to be exhibited more markedly.

The crystal body of the present invention only needs to have a crystal structure in at least part of it and may contain a part of an amorphous structure.

However, the ratio of the part having the crystal structure in the crystal body of the present invention is preferably 80% by mass or more, more preferably 90% by mass or more, and even more preferably 95% by mass or more.

The ratio between the part of the crystal structure and the part of the amorphous structure in the crystal body of the present invention can be determined by measurement using X-ray diffraction.

The crystal body of the present invention may be for any application, and examples of the application of the crystal body of the present invention include optical materials such as UV absorbers, optical sensors, wavelength conversion materials, and phosphors.

In particular, the crystal body of the present invention is composed of relatively inexpensive and stably available components and exhibits excellent optical characteristics as described above, and is thus preferably applied to phosphors.

The crystal body of the present invention can be excited by short-wavelength near-ultraviolet to blue light and emit long-wavelength red to near-infrared light, and can thus be suitably applied to, for example, wavelength conversion materials for wavelength conversion films for solar cells such as silicon.

As the phosphor, it can be used, for example, for light-emitting elements for displays, light-emitting elements for lighting, scintillators, and the like.

As the UV absorber, it can be used, for example, for UV-absorbing materials in UV-absorbing sheets, foundations, lotions, sunscreens, and the like.

As the optical sensor, it can be used, for example, for light detection elements in photodetectors and the like.

Ga at the Ga sites may be substituted by another element other than Mn to the extent that the effects of the present invention are not impaired. Examples of the other element at the Ga sites include Y, La, Ce, Pr, Nd, Pm, Sm, Eu, Gd, Tb, Dy, Ho, Er, Tm, Yb, Lu, and Al. In the crystal body of the present invention, the other element is contained in a trivalent state at the Ga sites.

The substitution ratio of the other element other than Mn at the Ga sites is preferably 20 mol% or less, and more preferably 5 mol% or less in terms of mol% of the other element with respect to all elements at the Ga sites ((amount by mole of other elements other than Mn/amount by mole of all elements at Ga sites) × 100).

Sr at the Sr sites may be substituted by another element to the extent that the effects of the present invention are not impaired. Examples of the other element include Mg, Zn, Cu, Co, Ni, Fe, Mn, Ce, and Sn. In the crystal body of the present invention, the other element is contained in a divalent state at the Sr sites.

The substitution ratio of the other element at the Sr sites is preferably 20 mol% or less, and more preferably 5 mol% or less in terms of mol% of the other element with respect to all elements at the Sr sites ((amount by mole of other elements/amount by mole of all elements at Sr sites) × 100).

Ca at the Ca sites may be substituted by another element to the extent that the effects of the present invention are not impaired. Examples of the other element include Mg, Zn, Cu, Co, Ni, Fe, Mn, Ce, and Sn. In the crystal body of the present invention, the other element is contained in a divalent state at the Ca sites.

The substitution ratio of the other element at the Ca sites is preferably 20 mol% or less, and more preferably 5 mol% or less in terms of mol% of the other element with respect to all elements at the Ca sites ((amount by mole of other elements/amount by mole of all elements at Ca sites) × 100).

In the crystal body of the present invention, the molar ratio of each site in the entire crystal body is preferably "all Sr site elements:all Ca site elements:all Ga site elements:all O site O elements = 1.00:2.00:2.00:6.00," but the ratio of one or more sites may deviate from the above range to the extent that the effects of the present invention are not impaired. Preferably, "all Sr site elements:all Ca site elements:all Ga site elements:all O site O elements = 1.00 ± 0.05:2.00 ± 0.10:2.00 ± 0.10:6.00 ± 0.30."

### <Crystal Body of Second Aspect of Present Invention>

### (1) Crystal Body

In the following description, a case in which the crystal body of the present invention is an optical material, especially a phosphor, will be mainly described, but this is not limiting. The crystal body of the present invention can be applied as various optical materials other than the phosphor or materials other than optical materials in a wide range of applications as described below.

The crystal body of the present invention has an oxide matrix composed of BaSr₂Ca₆Ga₆O₁₈. In other words, the crystal body of the present invention has a crystal structure of BaSr₂Ca₆Ga₆O₁₈, and has an oxide matrix composed of at least Ba, Sr, Ca, and Ga.

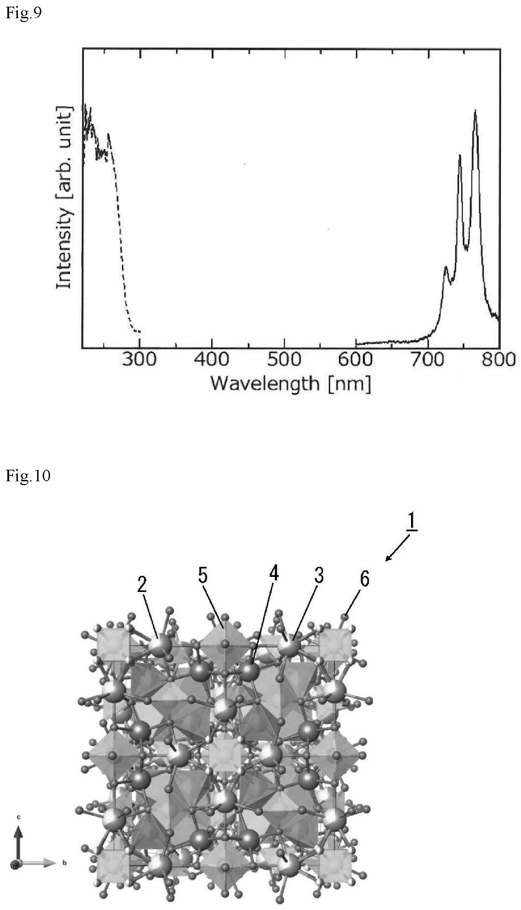

The crystal body having an oxide matrix composed of BaSr₂Ca₆Ga₆O₁₈ will be described using FIG. 10. FIG. 10 is a schematic diagram of the crystal body having an oxide matrix composed of BaSr₂Ca₆Ga₆O₁₈. In FIG. 10, Crystal Body (1) is a crystal structure of BaSr₂Ca₆Ga₆O₁₈, with the constituent elements disposed at its Ba sites, Sr sites, Ca sites, and Ga sites. Crystal Body (1) in FIG. 10 is composed of Ba (2) disposed at the Ba sites, Sr (3) disposed at the Sr sites, Ca (4) disposed at the Ca sites, Ga (5) disposed at the Ga sites, and O (6). Crystal Body (1) is the crystal structure of BaSr₂Ca₆Ga₆O₁₈ with part of Ga at the Ga sites substituted by Mn.

In the present invention, having an oxide matrix composed of BaSr₂Ca₆Ga₆O₁₈ means having the same crystal structure as that of BaSr₂Ca₆Ga₆O₁₈ and that the matrix in which some of the Ba sites, the Sr sites, the Ca sites, or the Ga sites are substituted by another element is BaSr₂Ca₆Ga₆O₁₈. In other words, in the present invention, the crystal body having an oxide matrix composed of BaSr₂Ca₆Ga₆O₁₈ means a crystal body having the same crystal structure as that of BaSr₂Ca₆Ga₆O₁₈ and having BaSr₂Ca₆Ga₆O₁₈ as its matrix with some of its Ba sites, Sr sites, Ca sites and/or Ga sites substituted by another element. The crystal body of the present invention only needs to have an oxide matrix composed of BaSr₂Ca₆Ga₆O₁₈ and may contain elements different from the elements constituting the oxide matrix, and the characteristics of the crystal body can be suitably adjusted by the kind, the content, and the like of such elements.

In the present invention, the crystal structure of BaSr₂Ca₆Ga₆O₁₈ is the structure of SrCa₂Ga₂O₆ with one-third of the Sr sites substituted by Ba. The inventors of the present invention have found that a crystal body of SrCa₂Ga₂O₆ with one-third of the Sr sites substituted by Ba, that is, a crystal body having an oxide matrix composed of BaSr₂Ca₆Ga₆O₁₈ absorbs light in the ultraviolet to visible light region and emits light in the visible to infrared light region, and further has excellent absorption in the blue light region from 450 to 500 nm in addition to the novel fluorescence characteristics exhibited by the above-described crystal body having an oxide matrix composed of SrCa₂Ga₂O₆ (red emission on the longer wavelength side (emission on the longer wavelength side than 670 nm and emission in a narrow band)). Therefore, the crystal body of the present invention can be suitably applied, for example, to phosphors for white LEDs, UV absorbers, phosphors for wavelength conversion films for silicon solar cells, wavelength conversion materials for agricultural sheets for plant growth control, security fields, biosensors, and the like. As will be described below in detail, the crystal body of the present invention only needs to have an oxide matrix composed of BaSr₂Ca₆Ga₆O₁₈ and may contain elements different from the elements constituting the oxide matrix, and the characteristics of the crystal body can be suitably adjusted by the kind, the content, and the like of such elements.

As described above, the crystal body of the present invention may contain elements other than the elements constituting the oxide matrix composed of BaSr₂Ca₆Ga₆O₁₈ (that is, Ba, Sr, Ca, Ga, and O) (hereinafter also referred to as "another element"). In other words, for at least one of the Ba sites, the Sr sites, the Ca sites, and the Ga sites constituting BaSr₂Ca₆Ga₆O₁₈, at least some of the elements constituting the sites may be substituted by another element.

However, the content of the other element in the crystal body of the present invention is preferably 5.0% by mass or less, more preferably 0.01% by mass or more and 4.0% by mass or less, and even more preferably 0.1% by mass or more and 3.0% by mass or less.

The crystal body of the present invention is preferably Formula (2) below:

BaSr₂Ca₆(Ga₍₁₋ₓ₎Mₓ)₆O₁₈ (2)

in Formula (2), M is one or more selected from the group consisting of Mn, Cr, Fe, Ti, Bi, V, and rare earth elements; and the relation 0 < x ≤ 0.10 is satisfied. x is 0 < x ≤ 0.10, preferably 0.001 ≤ x ≤ 0.09, and more preferably 0.01 ≤ x ≤ 0.07. By being the oxide represented by Formula (2), the crystal body of the present invention is a crystal body that emits light in the visible to infrared light region. In particular, it has a novel crystal structure different from those of conventional crystal bodies, and provides fluorescence characteristics that cannot be obtained by compounds with known crystal structures, such as red emission on the longer wavelength side (emission on the longer wavelength side than 670 nm) and emission in a narrower band than those of compounds with conventional crystal structures. Furthermore, the crystal body of the present invention being the oxide represented by Formula (2) is preferred in that it increases the effect of making absorption of light from 300 to 600 nm, preferably from 300 to 550 nm stronger and making emission of light from 650 to 900 nm, preferably from 650 to 750 nm stronger.

The crystal body of the present invention is preferably an oxide represented by Formula (3) below:

(Ba_{(1-α)}A1_{α})ₚ(Sr_{(1-β)}A2_{β})_{q}(Ca_{(1-γ)}A3_{γ})ᵣ(Ga_{(1-x-δ)}MₓA4_{δ})ₛOₜ (3)

where A1, A2, and A3 are one or more selected from the group consisting of Mg, Zn, Cu, Co, Ni, Fe, Mn, Ce, and Sn; A1, A2, and A3 may be the same or different; A4 is one or more selected from the group consisting of Y, La, Ce, Pr, Nd, Pm, Sm, Eu, Gd, Tb, Dy, Ho, Er, Tm, Yb, Lu, and Al; M is one or more selected from the group consisting of Mn, Cr, Fe, Ti, Bi, V, and rare earth elements; 0.00 ≤ α ≤ 0.20; 0.00 ≤ β ≤ 0.20; 0.00 ≤ γ ≤ 0.20; 0.00 ≤ δ ≤ 0.20; 0 < x ≤ 0.10; p = 1.00 ± 0.05; q = 2.00 ± 0.10; r = 6.00 ± 0.30; s = 6.00 ± 0.30; and t = 18.00 ± 0.90. By being the oxide represented by Formula (3), the crystal body of the present invention is a crystal body that emits light in the visible to infrared light region. In particular, it has a novel crystal structure different from those of conventional crystal bodies, and provides fluorescence characteristics that cannot be obtained by compounds with known crystal structures, such as red emission on the longer wavelength side (emission on the longer wavelength side than 670 nm) and emission in a narrower band than those of compounds with conventional crystal structures. Furthermore, the crystal body of the present invention being the oxide represented by Formula (3) is preferred in that it increases the effect of making absorption of light from 300 to 600 nm, preferably from 300 to 550 nm stronger and making emission of light from 650 to 900 nm, preferably from 650 to 750 nm stronger.

α is 0.00 ≤ α ≤ 0.20, preferably 0.00 ≤ α ≤ 0.10, and more preferably 0.00 ≤ α ≤ 0.05.

β is 0.00 ≤ β ≤ 0.20, preferably 0.00 ≤ β ≤ 0.10, and more preferably 0.00 ≤ β ≤ 0.05.

γ is 0.00 ≤ γ ≤ 0.20, preferably 0.00 ≤ γ ≤ 0.10, and more preferably 0.00 ≤ γ ≤ 0.05.

δ is 0.00 ≤ δ ≤ 0.20, preferably 0.00 ≤ δ ≤ 0.10, and more preferably 0.00 ≤ δ ≤ 0.05.

x is 0 < x ≤ 0.10, preferably 0.001 ≤ x ≤ 0.09, and more preferably 0.01 ≤ x ≤ 0.07.

p is p = 1.00 ± 0.05, preferably p = 1.00 ± 0.01, and more preferably p = 1.000 ± 0.001.

q is q = 2.00 ± 0.10, preferably q = 2.00 ± 0.02, and more preferably q = 2.000 ± 0.002.

r is r = 6.00 ± 0.30, preferably r = 6.00 ± 0.06, and more preferably r = 6.000 ± 0.006.

s is s = 6.00 ± 0.30, preferably s = 6.00 ± 0.06, and more preferably s = 6.000 ± 0.006.

t is t = 18.00 ± 0.90, preferably t = 18.00 ± 0.18, and more preferably t = 18.000 ± 0.018.

The values of α, β, γ, δ, x, p, q, r, s and/or t being within the above ranges are preferred in that such values increase the effect of making absorption of light from 300 to 600 nm, preferably from 300 to 550 nm stronger and making emission of light from 650 to 900 nm, preferably from 650 to 750 nm stronger.

In the crystal body of the present invention, part of Ga constituting the oxide matrix composed of BaSr₂Ca₆Ga₆O₁₈ is preferably substituted by another element in that it makes absorption of light from 300 to 350 nm and from 450 to 500 nm stronger and makes emission of light from 650 to 900 nm, preferably from 650 to 750 nm stronger.

Examples of the other element M substituting Ga at the Ga sites include Mn, Cr, Fe, Ti, Bi, V, and rare earth elements. One or more elements M selected from Mn, Cr, Fe, Ti, Bi, V, and rare earth elements can be used, but M is preferably one or more selected from the group consisting of Mn, Cr, and rare earth elements, more preferably one or more selected from the group consisting of Mn and Cr, and even more preferably Mn. M is an element serving as a luminescent center when used as a phosphor. This increases the effect of making absorption of light from 300 to 600 nm, preferably from 300 to 550 nm stronger and making emission of light from 650 to 900 nm, preferably from 650 to 750 nm stronger.

In the crystal body of the present invention, Mn may be contained in a tetravalent (Mn⁴⁺) state or contained in a divalent (Mn²⁺) state, but is preferably contained in a tetravalent (Mn⁴⁺) state. In the crystal body of the present invention, Cr, Bi, Fe, Ti, V, and rare earth elements are contained in a trivalent state (M³⁺) at the Ga sites.

The substitution ratio of M at the Ga sites is more than 0 mol% and 10 mol% or less, preferably 0.1 to 9 mol%, and more preferably 1 to 7 mol% in terms of mol% of M with respect to all elements at the Ga sites ((amount by mole of M/amount by mole of all elements at Ga sites) × 100). The substitution ratio of M at the Ga sites being within the above range increases the effect of making absorption of light from 300 to 600 nm, preferably from 300 to 550 nm stronger and making emission of light from 650 to 900 nm, preferably from 650 to 750 nm stronger. When a plurality of kinds of M are present, the amount by mole of M is the total amount by mole of those M.

Ga at the Ga sites may be substituted by another element A4 other than M to the extent that the effects of the present invention are not impaired. Examples of A4 include Y, La, Ce, Pr, Nd, Pm, Sm, Eu, Gd, Tb, Dy, Ho, Er, Tm, Yb, Lu, and Al. In the crystal body of the present invention, A4 is contained in a trivalent state (A4³⁺) at the Ga sites.

The substitution ratio of A4 at the Ga sites is 20 mol% or less, preferably 10 mol% or less, and more preferably 5 mol% or less in terms of mol% of A4 with respect to all elements at the Ga sites ((amount by mole of A4/amount by mole of all elements at the Ga sites) × 100). When a plurality of kinds of A4 are present, the amount by mole of A4 is the total amount by mole of those A4.

Ba at the Ba sites may be substituted by another element A1 to the extent that the effects of the present invention are not impaired. Examples of A1 include Mg, Zn, Cu, Co, Ni, Fe, Mn, Ce, and Sn. In the crystal body of the present invention, A1 is contained in a divalent state (A1²⁺) at the Ba sites.

The substitution ratio of A1 at the Ba sites is 20 mol% or less, preferably 10 mol% or less, and more preferably 5 mol% or less in terms of the mol% of A1 with respect to all elements at the Ba sites ((amount by mole of A1/amount by mole of all elements at the Ba sites) × 100). When a plurality of kinds of A1 are present, the amount by mole of A1 is the total amount by mole of those A1.

Sr at the Sr sites may be substituted by another element A2 to the extent that the effects of the present invention are not impaired. Examples of A2 include Mg, Zn, Cu, Co, Ni, Fe, Mn, Ce, and Sn. In the crystal body of the present invention, A2 is contained in a divalent state (A2²⁺) at the Sr sites.

The substitution ratio of A2 at the Sr sites is 20 mol% or less, preferably 10 mol% or less, and more preferably 5 mol% or less in terms of mol% of A2 with respect to all elements at the Sr sites ((amount by mole of A2/amount by mole of all elements at the Sr sites) × 100). When a plurality of kinds of A2 are present, the amount by mole of A2 is the total amount by mole of those A2.

Ca at the Ca sites may be substituted by another element A3 to the extent that the effects of the present invention are not impaired. Examples of A3 include Mg, Zn, Cu, Co, Ni, Fe, Mn, Ce, and Sn. In the crystal body of the present invention, A3 is contained in a divalent state (A2²⁺) at the Ca sites.

The substitution ratio of A3 at the Ca sites is 20 mol% or less, preferably 10 mol% or less, and more preferably 5 mol% or less in terms of mol% of A3 with respect to all elements at the Ca sites ((amount by mole of A3/amount by mole of all elements at the Ca sites) × 100). When a plurality of kinds of A3 are present, the amount by mole of A3 is the total amount by mole of those A3.

In the crystal body of the present invention, the molar ratio of each site in the entire crystal body is preferably "all Ba site elements:all Sr site elements:all Ca site elements:all Ga site elements:all O site O elements = 1.00:2.00:6.00:6.00:18.00," but the elements at each site may deviate from the above range to the extent that the effects of the present invention are not impaired. Preferably "all Ba site elements:all Sr site elements:all Ca site elements:all Ga site elements:all O site O elements = 1.00 ± 0.05:2.00 ± 0.10:6.00 ± 0.30:6.00 ± 0.30:18.00 ± 0.90," more preferably "all Ba site elements:all Sr site elements:all Ca site elements:all Ga site elements:all O site O elements = 1.00 ± 0.01:2.00 ± 0.02:6.00 ± 0.06:6.00 ± 0.06:18.00 ± 0.18," and more preferably "all Ba site elements:all Sr site elements:all Ca site elements:all Ga site elements:all O site O elements = 1.000 ± 0.001:2.000 ± 0.002:6.000 ± 0.006:6.000 ± 0.006:18.000 ± 0.018."

The crystal structure of the crystal body of the present invention is the Turulight structure series, and is a structure having a space group of a cubic system such as F432.

The crystal body of the present invention, having the above configuration, shows red emission having a peak around 710 nm by irradiation with light from 300 to 600 nm.

The crystal body of the present invention only needs to have a crystal structure in at least part of it and may contain a part of an amorphous structure.

However, the ratio of the part having the crystal structure in the crystal body of the present invention is preferably 80% by mass or more, more preferably 90% by mass or more, and even more preferably 95% by mass or more.

The ratio between the part of the crystal structure and the part of the amorphous structure in the crystal body of the present invention can be determined by measurement using X-ray diffraction.

The average particle size of the crystal body of the present invention is preferably 1 nm to 100 µm, more preferably 10 to 100 µm, and even more preferably 15 to 50 µm. In the present invention, the average particle size is a value obtained by taking a picture of particles using a scanning electron microscope (SEM: JSM-7900F, manufactured by JEOL Ltd.) at an acceleration voltage of 8 kV, measuring the short diameters of 100 arbitrarily selected particles, and calculating their average. For image analysis, WinROOF, image analysis and measurement software, is used.

Since the crystal body of the present invention is composed of relatively inexpensive and stably available components by the above configuration, it may be applied to various applications, and can provide a crystal body having an oxide matrix having a novel structure, that is, an oxide matrix composed of SrCa₂Ga₂O₆ or an oxide matrix composed of BaSr₂Ca₆Ga₆O₁₈ that is expected to exhibit new characteristics. Furthermore, the crystal body of the present invention can achieve diversified applications and improve performance by substituting the elements of the oxide matrix composed of SrCa₂Ga₂O₆ or the oxide matrix composed of BaSr₂Ca₆Ga₆O₁₈ by another element.

The crystal body of the present invention can provide a crystal body that is composed of relatively inexpensive and stably available components and can be used as a phosphor having excellent characteristics. Furthermore, the crystal body of the present invention can provide a crystal body that emits light in the visible to infrared light region by substituting the elements of the oxide matrix by another element. In particular, the crystal body of the present invention has a novel crystal structure different from those of conventional crystal bodies, and provides fluorescence characteristics that cannot be obtained by compounds with known crystal structures, such as red emission on the longer wavelength side (emission on the longer wavelength side than 670 nm) and emission in a narrower band than those of compounds with conventional crystal structures. Therefore, the crystal body of the present invention can be suitably applied to red phosphors for white LEDs, wavelength conversion materials for silicon solar cells, and the like.

The crystal body of the present invention may be for any application, and examples of the application of the crystal body of the present invention include optical materials such as UV absorbers, optical sensors, wavelength conversion materials, and phosphors. In particular, the crystal body of the present invention exhibits excellent effects as the phosphor.

The crystal body of the present invention can be excited by short-wavelength near-ultraviolet to blue light and emit long-wavelength red to near-infrared light, and can thus be suitably applied to, for example, wavelength conversion materials for wavelength conversion films for solar cells such as silicon.

As the phosphor, it can be used, for example, for plant growth promoting materials, light-emitting elements for displays, light-emitting elements for lighting, scintillators, and the like.

As the UV absorber, it can be used, for example, for UV-absorbing materials in UV-absorbing sheets, foundations, lotions, sunscreens, and the like.

As the optical sensor, it can be used, for example, for light detection elements in photodetectors and the like.

### (2) Method for Producing Crystal Body

Next, a method for producing the crystal body of the present invention (a method for producing the crystal body of the first aspect of the present invention and the second aspect of the present invention) will be described. Since the method for producing the crystal body of the second aspect of the present invention and the crystal body of the first aspect of the present invention are similar except for the difference in whether the material of a Ba source is essential, the differences will each be described below, and the similarities will be described by collectively referring to the method for producing the crystal body of the second aspect of the present invention and the method for producing the crystal body of the first aspect of the present invention as the method for producing the crystal body of the present invention.

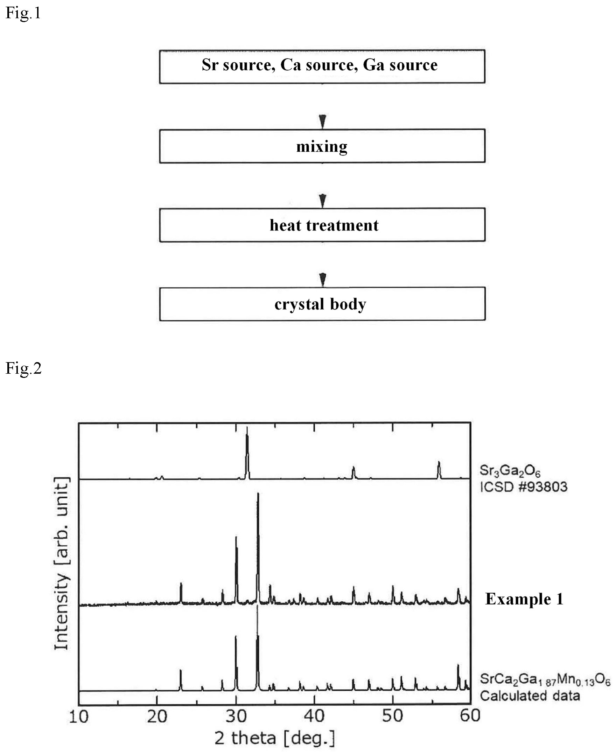

FIG. 1 is a flowchart of an example of steps of the method for producing the crystal body of the present invention.

The crystal body of the present invention can be suitably produced, for example, by using a method having a mixing step of mixing, as raw materials, the material of a Sr source, the material of a Ca source, and the material of a Ga source (the first aspect) or mixing at least the material of the Ba source, the material of the Sr source, the material of the Ca source, and the material of the Ga source (the second aspect) and a heat treatment step of performing heat treatment on a mixture obtained in the mixing step.

This can suitably produce a crystal body that is composed of relatively inexpensive and stably available components and can be used as a phosphor having excellent characteristics.

Each step will be described below.

### (2-1) Mixing Step

In the mixing step, in the first aspect, the material of the Sr source, the material of the Ca source, and the material of the Ga source are mixed, and in the second aspect, at least the material of the Ba source, the material of the Sr source, the material of the Ca source, and the material of the Ga source are mixed to obtain a raw material mixture.

To correspond to the composition of the crystal body to be produced, in the mixing step, in the first aspect, raw materials other than the material of the Sr source, the material of the Ca source, and the material of the Ga source (that is, the material of the other element source), and in the second aspect, raw materials other than the material of the Ba source, the material of the Sr source, the material of the Ca source, and the material of the Ga source (that is, the material of the other element source) may be further used.

The timing of mixing each component in the mixing step is not limited to particular timing. For example, all the raw materials may be mixed at once, or a specific plurality of kinds of raw material components may be mixed, followed by further mixing of the other raw material components.

As the Sr source, the Ca source, the Ga source, and the Ba source, any compounds containing Sr, Ca, Ga, and Ba, respectively, can be used. For example, oxides, carbonates, hydroxides, and the like of these can be suitably used. Among them, at least one of metal carbonates and metal oxides is preferably used.

This makes it possible to suitably perform the reaction in the heat treatment step as the subsequent step.

Hydrates may be used as these compounds. In the following description of preferred compounds, the hydration water of hydrates is omitted.

Examples of the Sr source include strontium oxide (SrO), strontium carbonate (SrCO₃), and strontium hydroxide (Sr(OH)₂).

Examples of the Ca source include calcium oxide (CaO), calcium carbonate (CaCO₃), and calcium hydroxide (Ca(OH)₂).

Examples of the Ga source include gallium oxide (Ga₂O₃), gallium carbonate (Ga₂(CO₃)₃), and gallium hydroxide (Ga(OH)₃).

Examples of the Ba source include barium oxide (BaO), barium carbonate (BaCO₃), and barium hydroxide (Ba(OH)₂).

Examples of a Mn source as the other element source include manganese oxide (MnO, Mn₃O₄, Mn₂O₃, MnO₂, MnO₃, and Mn₂O₇), manganese carbonate (MnCO₃), and manganese hydroxide (Mn(OH)₂).

Examples of a Cr source as the other element source include chromium oxide (CrO, Cr₂O₃, CrO₂, and CrO₃), chromium carbonate (Cr₂(CO₃)₃), and chromium hydroxide (Cr(OH)₂ and Cr(OH)₃).

Examples of a Bi source as the other element source include bismuth oxide (Bi₂O₃), bismuth carbonate (Bi₂(CO₃)₃), and bismuth hydroxide (Bi(OH)₃).

As a rare earth element source as the other element source, for example, oxides, carbonates, hydroxides, and the like of rare earth elements can be used.

More specifically, when the rare earth element is, for example, Sc, examples of a Sc source as the rare earth element source include scandium oxide (Sc₂O₃), scandium carbonate (Sc₂(CO₃)₃), and scandium hydroxide (Sc(OH)₃).

When the rare earth element is, for example, Pr, examples of a Pr source as the rare earth element source include praseodymium oxide (Pr₆O₁₁, Pr₂O₃, and the like), praseodymium carbonate (Pr₂(CO₃)₃ and Pr(CO₃)₂), and praseodymium hydroxide (Pr(OH)₃ and Pr(OH)₄).

When the rare earth element is, for example, Sm, examples of a Sm source as the rare earth element source include samarium oxide (Sm₂O₃), samarium carbonate (SmCO₃ and Sm₂(CO₃)₃), and samarium hydroxide (Sm(OH)₂ and Sm(OH)₃).

When the rare earth element is, for example, Eu, examples of a Eu source as the rare earth element source include europium oxide (Eu₂O₃), europium carbonate (EuCO₃ and Eu₂(CO₃)₃), and europium hydroxide (Eu(OH)₂).

When the rare earth element is, for example, Tb, examples of a Tb source as the rare earth element source include terbium oxide (Tb₂O₃, and Tb₄O₇), terbium carbonate (Tb₂(CO₃)₃, and Tb(CO₃)₂), and terbium hydroxide (Tb(OH)₃ and Tb(OH)₄).

When the rare earth element is, for example, Tm, examples of a Tm source as the rare earth element source include thulium oxide (Tm₂O₃), thulium carbonate (TmCO₃ and Tm₂(CO₃)₃), and thulium hydroxide (Tm(OH)₂ and Tm(OH)₃).

In the mixing step, the Sr source, the Ca source, the Ga source, and the Ba source (and the other element source as needed) described above are mixed in accordance with a certain ratio, for example, a stoichiometric ratio to make the raw material mixture.

The method of mixing for the raw material mixture may be either dry mixing or wet mixing, but wet mixing is preferred from the viewpoint of the capability of mixing the raw materials more uniformly.

As a solvent for use in wet mixing, for example, organic solvents such as methanol, acetone, benzene, and carbon tetrachloride are used.

As the method of mixing, mixing can be performed using, for example, fixed mixers such as agitators, spiral mixers, ribbon mixers, and fluidizing mixers, rotary mixers such as cylindrical mixers and twin cylindrical mixers, wet mills such as sand mills, ball mills, bead mills, colloid mills, and sand grinder mills, shakers such as paint shakers, dispersion machines such as ultrasonic dispersion machines, and the like.

The raw material mixture obtained as described above may be mixed with flux, for example, prior to the heat treatment step described below.

This enables the crystal body to be obtained in a more suitable crystalline state (for example, one composed of a single crystal).

As the flux, for example, SrCl₂ or the like can be used.

For example, the material of the Sr source, the material of the Ca source, the material of the Ga source, the material of the Ba source, and the like may be sequentially fed into the flux to obtain the raw material mixture.

Also in such cases, the same effect as above can be obtained.

### (2-2) Heat Treatment Step

In the heat treatment step, heat treatment is performed on the raw material mixture.

The heat treatment method in the heat treatment step is not limited to a particular method so long as it can heat the raw material mixture, and various apparatuses and methods can be used.

The heat treatment step preferably performs heat treatment at 1,000°C or higher and 1,600°C or lower for 3 hours or more and 10 hours or less.

This enables the reaction in the heat treatment step to proceed more suitably. In addition, the crystal body can be synthesized by heat treatment at relatively low temperatures, thereby eliminating the need for special equipment and the like and also leading to a reduction in production costs.

The heating temperature in the heat treatment step is preferably 1,000°C or higher and 1,600°C or lower as described above, but is more preferably 1,050°C or higher and 1,550°C or lower, and even more preferably 1,100°C or higher and 1,500°C or lower. The heating time in the heat treatment step is preferably 3 hours or more and 10 hours or less as described above, but is more preferably 3.5 hours or more and 9 hours or less, and even more preferably 4 hours or more and 8 hours or less.

This enables the reaction in the heat treatment step to proceed even more suitably.

The atmosphere in the heat treatment step is not limited to a particular atmosphere, and the heat treatment step may be performed, for example, in air or in an inert gas atmosphere.

Examples of the inert gas include argon gas, helium gas, and nitrogen gas.

The heat treatment step may be performed, for example, in a mixed gas atmosphere of the inert gas and hydrogen gas.

The ratio of the hydrogen gas in the mixed gas can be, for example, 1.0% by volume or more and 10.0% by volume or less.

The heat treatment step described above may be performed in one step or performed in two or more steps under different conditions.

For example, when the heat treatment step is performed divided into a first stage and a second stage, the atmosphere may be changed between the first stage and the second stage.

For example, when the heat treatment step is performed in the first stage and the second stage described above, the first stage may be performed in air and the second stage may be performed in a mixed gas atmosphere of inert gas and hydrogen gas.

This enables the reactions in the first stage and the second stage of the heat treatment step to proceed more suitably.

A solid reactant may be milled between the first stage and the second stage.

This enables the reaction in the second stage of the heat treatment step to proceed even more suitably.

The above describes suitable embodiments of the present invention, but the present invention is not limited to these.

For example, the crystal body of the present invention only needs to have an oxide matrix composed of SrCa₂Ga₂O₆ and is not limited to those produced by the above-described method of production.

For example, the crystal body of the present invention only needs to have an oxide matrix composed of BaSr₂Ca₆Ga₆O₁₈ and is not limited to those produced by the above-described method of production.

The above-described method for producing the crystal body may further include other steps in addition to the above-described steps.

More specifically, for example, in the method for producing the crystal body, milling and/or classification may be performed after the mixing step and/or the heat treatment step as needed. Milling may be either wet milling or dry milling. In dry milling, for example, dry mills such as mortars, roll crushers, atomizers, hammer mills, jet mills, fluid energy mills, and mix mullers may be used as needed.

For example, the powdery crystal body obtained by milling may be dispersed in a liquid and then collected by solid-liquid separation to remove impurities. This can, for example, further improve the luminous efficiency of the crystal body.

Solid-liquid separation can be performed by methods industrially normally used, such as filtration, suction filtration, pressure filtration, centrifugation, and decantation. The crystal body collected by solid-liquid separation can be dried using apparatuses industrially normally used, such as vacuum dryers, hot air dryers, conical dryers, and rotary evaporators.

The phosphor of the present invention contains the crystal body of the present invention (the crystal body of the first aspect of the present invention or the crystal body of the second aspect of the present invention), in which some of the elements of the crystal body are substituted by an element serving as a luminescent center. In other words, the crystal body of the present invention (the crystal body of the first aspect of the present invention or the crystal body of the second aspect of the present invention), in which some of the elements of the crystal body are substituted by an element serving as a luminescent center, is a phosphor as a wavelength conversion material.

In the phosphor of the present invention, the element serving as a luminescent center is the M element, that is, one or more selected from the group consisting of Mn, Cr, Fe, Ti, Bi, and rare earth elements, preferably one or more selected from the group consisting of Mn, Cr, and rare earth elements, more preferably one or more selected from the group consisting of Mn and Cr, and even more preferably Mn.

Examples of the phosphor of the present invention include those containing the crystal body of the present invention (the crystal body of the first aspect of the present invention or the crystal body of the second aspect of the present invention), the crystal body being the oxide represented by Formula (1), the oxide represented by Formula (2), or the oxide represented by Formula (3).

The average particle size of the phosphor of the present invention is preferably 1 nm to 100 µm, more preferably 10 nm to 100 µm, and even more preferably 15 nm to 50 µm.

The fluorescent material of the present invention includes the phosphor of the present invention. In other words, the fluorescent material of the present invention contains the phosphor of the present invention, or includes the phosphor of the present invention and includes other components as needed.

Examples of the fluorescent material of the present invention include the phosphor of the present invention surface-coated with a light transmissive resin. In other words, examples of the fluorescent material of the present invention include fluorescent materials containing the phosphor of the present invention and a light transmissive resin coating the surface of the phosphor of the present invention.

The light transmissive resin has a haze (JIS-K-7136) of 10% or less and a total light transmittance (JIS-K-7361) of 80% or more.

Examples of the light transmissive resin include polyethylene resins, polyvinyl chloride resins, acrylic resins, polycarbonate resins, polystyrene resins, polyamide resins, polypropylene resins, polyolefin resins, silicone resins, polyethylene terephthalate-based resins (PET resins), polybutylene terephthalate-based resins (PBT resins), and polytetramethylene terephthalate-based resins (PTT).

When the fluorescent material of the present invention is a fluorescent material containing the phosphor of the present invention and the light transmissive resin coating the surface of the phosphor of the present invention, the thickness of the light transmissive resin is preferably 0.1 nm to 10 µm, and more preferably 1 nm to 5 µm because the performance of the coating is not exhibited if the coating amount of the light transmissive resin is too thin and transparency is impaired if it is too thick.

When the fluorescent material of the present invention is a fluorescent material containing the phosphor of the present invention and the light transmissive resin coating the surface of the phosphor of the present invention, when a resin sheet in which the phosphor of the present invention is dispersed is produced, the phosphor of the present invention is easily dispersed in the resin, and thus it is easy to obtain the resin sheet in which the phosphor of the present invention is uniformly dispersed.

In the fluorescent material of the present invention, the method for coating the surface of the phosphor of the present invention with the light transmissive resin is not limited to a particular method, and examples thereof include a method of dispersing the phosphor of the present invention in a solvent, adding a monomer of the light transmissive resin thereto, then adding a polymerization initiator, polymerizing the monomer of the light transmissive resin by heating or the like to generate the light transmissive resin on the surface of the phosphor of the present invention, thereby coating the surface of the phosphor of the present invention with the light transmissive resin.

Examples of the fluorescent material of the present invention include a fluorescent material having a core-shell structure including a core containing the phosphor of the present invention and a shell formed on the surface of the core and made of a material with a lower refractive index than that of the core. Examples of the material forming the shell include resin materials and inorganic materials, and those with a lower refractive index than that of the core are suitably used from the viewpoint of light transmittance.

When the fluorescent material of the present invention is a fluorescent material having a core-shell structure including a core containing the phosphor of the present invention and a shell formed on the surface of the core and made of a material with a lower refractive index than that of the core, it is possible to, for example, increase light intake efficiency and improve durability owing to the shell blocking external degradation factors by the material of the shell.

The fluorescent material of the present invention can contain a spreading agent. The spreading agent has a function of enhancing the wettability, adherability, spreadability, suspensibility, and the like of the phosphor of the present invention or the fluorescent material of the present invention and uniformly causing the phosphor of the present invention or the fluorescent material of the present invention to adhere. In particular, when the phosphor of the present invention or the fluorescent material of the present invention is used as a plant growth promoting material for agriculture, when the phosphor of the present invention or the fluorescent material of the present invention is directly sprayed onto plants to cause it to directly adhere to leaves, stems, and the like of plants, a dispersion liquid in which the phosphor of the present invention or the fluorescent material of the present invention is dispersed in a water-based solvent is sprayed onto plants to cause it to adhere to plants, in which the spreading agent is used in order to cause the phosphor of the present invention or the fluorescent material of the present invention to uniformly adhere to the surface of plants at a moderate density when the dispersion liquid containing the phosphor of the present invention or the fluorescent material of the present invention is sprayed onto plants.

The spreading agent is not limited to a particular spreading agent so long as it can be used for agriculture, and examples thereof include ones containing a nonionic surfactant such as a polyoxyethylene alkyl phenyl ether-based surfactant, a polyoxyethylene alkyl ether-based surfactant, a polyalkylene glycol alkyl ether-based surfactant, a polyoxyethylene fatty acid ester-based surfactant, a polyoxyethylene resin acid ester-based surfactant, a polyoxyethylene hexitan fatty acid ester-based surfactant, a sorbitan fatty acid ester-based surfactant, or a silicone-based surfactant as an active ingredient; ones containing an anionic surfactant such as a naphthyl methane sulfonate-based surfactant, a lignin sulfonate-based surfactant, or an alkyl sulfosuccinate-based surfactant as an active ingredient; and a cationic surfactant such as a tetraalkylammonium salt-based surfactant. Examples of commercially available spreading agents include Approach BI (registered trademark, manufactured by Maruwa Biochemical Co., Ltd.), Squash (registered trademark, manufactured by Maruwa Biochemical Co., Ltd.), Surfactant WK (registered trademark, manufactured by Maruwa Biochemical Co., Ltd.), Mixpower (registered trademark, manufactured by Syngenta Japan K.K.), and Supply (registered trademark, manufactured by OAT Agrio Co., Ltd.).

The content of the spreading agent in the fluorescent material of the present invention is selected as appropriate, and is, for example, 0.05 to 10% by mass, and preferably 0.1 to 1.0% by mass with respect to the phosphor.

When the fluorescent material of the present invention is a fluorescent material containing the phosphor of the present invention and the light transmissive resin coating the surface of the phosphor of the present invention, and the fluorescent material is dispersed in aqueous dispersion solvents such as water, alcohol, and mixed solvents thereof or lipophilic dispersion solvents such as aromatic hydrocarbons such as toluene, xylene, and benzene, aliphatic hydrocarbons such as pentane and hexane, ethers such as dioxane and dibutyl ether, and esters such as ethyl acetate, the fluorescent material of the present invention and the spreading agent can be mixed in the dispersion solvent.

The phosphor of the present invention can be dispersed in aqueous dispersion solvents such as water, alcohols, and mixed solvents thereof or lipophilic dispersion solvents such as aromatic hydrocarbons such as toluene, xylene, and benzene, aliphatic hydrocarbons such as pentane and hexane, ethers such as dioxane and dibutyl ether, and esters such as ethyl acetate. In that case, the phosphor of the present invention and the spreading agent can be mixed in the dispersion solvent.

Examples of the method of use of the phosphor of the present invention or the fluorescent material of the present invention when it is used as a plant growth material for agriculture include a method of dispersing the phosphor of the present invention or the fluorescent material of the present invention in a water-based solvent, and directly spraying the obtained dispersion liquid onto plants to cause the phosphor of the present invention to adhere to the surface of leaves, stems, and the like of plants.

The applications of the phosphor of the present invention or the fluorescent material of the present invention may be any applications so long as they are required to emit light in the visible to infrared light region, and preferably any applications so long as they are required to convert light from 300 to 600 nm, preferably from 300 to 550 nm to light from 650 to 900 nm, preferably from 650 to 750 nm and emit it. Examples of the applications of the phosphor of the present invention or the fluorescent material of the present invention include phosphors for white LEDs, UV absorbers, phosphors for wavelength conversion films for silicon solar cells, wavelength conversion materials for agricultural sheets for plant growth control, security fields, and biosensors.

The resin sheet of the present invention contains a light transmissive resin base material, and includes the phosphor of the present invention or the fluorescent material of the present invention.

The resin sheet of the present invention contains a light transmissive resin base material. In other words, the resin sheet of the present invention is a light transmissive resin formed into a sheet shape. Examples of the light transmissive resin according to the resin sheet of the present invention include those similar to the light transmissive resin according to the fluorescent material of the present invention.

The content of the phosphor of the present invention or the fluorescent material of the present invention in the resin sheet of the present invention is not limited to a particular content, and is preferably 1 to 20% by mass, and more preferably 1 to 10% by mass.

The resin sheet of the present invention may be one with a thickness of 250 µm or more commonly called "sheet," one with a thickness of 250 µm or less commonly called "sheet," or one commonly called "foil." In other words, the thickness of the resin sheet of the present invention is not limited to a particular thickness, and is selected as appropriate in accordance with the duration of use, usage environment, conditions of use, and the like.

When the resin sheet of the present invention is used as a wavelength conversion sheet for agriculture, for example, the thickness of the resin sheet of the present invention is preferably 10 to 150 µm.

The resin sheet of the present invention can contain spreading agents, agricultural materials, agrochemicals, biostimulants, inorganic matter such as silica, or the like as needed.

The resin sheet of the present invention is suitably used as an agricultural sheet.

### [Examples]

The present invention will be described below in detail based on specific examples, but the present invention is not limited to these examples.

The treatments for which no specific atmospheric conditions or temperature conditions are indicated were performed at 25°C in air.

### (3) Methods of Evaluation

First, the measurement conditions for the analysis methods used in the evaluation of the following examples are listed below.

### (3-1) X-ray Diffraction

Apparatus: MX-Labo (Mac Science Co., Ltd.)
X-ray: CuKα (λ = 1.54056 Å)
Current: 25 mA
Voltage: 40 kV

### (3-2) Photoluminescence

Apparatus: FP-6500 (JASCO Corporation)
Radiation source: 150 W xenon lamp
Excitation wavelength: 465 nm

The intensity of emitted light was measured when irradiated with excitation light (λₑₓ = 435 nm).

### (4) Production of Crystal Body

### (Example 1)

First, SrCO₃ powder as a Sr source, CaCO₃ powder as a Ca source, Ga₂O₃ powder as a Ga source, and MnO₂ powder as a Mn source were prepared, and weighed so as to give a ratio Sr:Ca:Ga:Mn of 1.00:2.00:1.94:0.06 in terms of molar ratio.

Next, the above raw materials were mixed using an agate mortar to obtain a raw material mixture. Here, the mixture was wet-mixed using acetone as a solvent.

Next, the same mass of flux (SrCl₂) was added to the above raw material mixture, and the mixture was heated to 1,200°C in air, and held at 1,200°C for 6 hours to obtain a solid material.

The solid material was then allowed to cool to room temperature to obtain a crystal body.

For the crystal body of Example 1, its crystal phase was identified by X-ray diffraction under the above-described measurement conditions.

The crystal body of the present example was a single crystal with a composition represented by SrCa₂(Ga_{0.97}Mn_{0.03})₂O₆.

Detailed crystallographic data obtained by structural analysis for the crystal body produced in Example 1 are as follows.
Crystal system: cubic system
Lattice shape: face-centered cubic lattice
Lattice constants: a = 15.475 Å, V = 3,705.8.475 Å³
Space group: F432
z-value: 24
Rl factor: 0.0344
wR2 factor: 0.0785

### (Example 2)

First, SrCO₃ powder as a Sr source, CaCO₃ powder as a Ca source, Ga₂O₃ powder as a Ga source, and MnO₂ powder as a Mn source were prepared, and weighed so as to give a ratio Sr:Ca:Ga:Mn of 1.00:2.00:1.94:0.06 in terms of molar ratio.

Next, the above raw materials were mixed using an agate mortar to obtain a raw material mixture. Here, the mixture was wet-mixed using acetone as a solvent.

This raw material mixture was placed on a plate made of Pt, placed in an alumina boat, and heat-treated at 1,200°C for 6 hours in air to obtain a solid material.

The solid material was then allowed to cool to room temperature. The resulting product was milled, and then sieved to obtain a powdery crystal body.

The crystal body of the present example was a single crystal with a composition represented by SrCa₂(Ga_{0.97}Mn_{0.03})₂O₆.

### (Examples 3 to 10)

Crystal bodies were produced in the same manner as in Example 2 except that the amounts of the Sr source, the Ca source, the Ga source, and the Mn source used were changed.

### (Example 11)

A crystal body was produced in the same manner as in Example 2 except that Cr₂O₃ powder as a Cr source was used instead of the MnO₂ powder as the Mn source in the preparation of the raw material mixture.

The ratio of components other than the above single crystal contained in the crystal body obtained in each of the examples was 1% by mass or less for each.

FIG. 2 illustrates an X-ray diffraction pattern of the crystal body of Example 1.

In the X-ray diffraction pattern illustrated in FIG. 2, the ICSD (Inorganic Crystal Structure Database) data for Sr₃Ga₂O₆ and simulation results of an X-ray diffraction pattern for SrCa₂Ga_{1.87}Mn_{0.13}O₆ are also illustrated for reference.

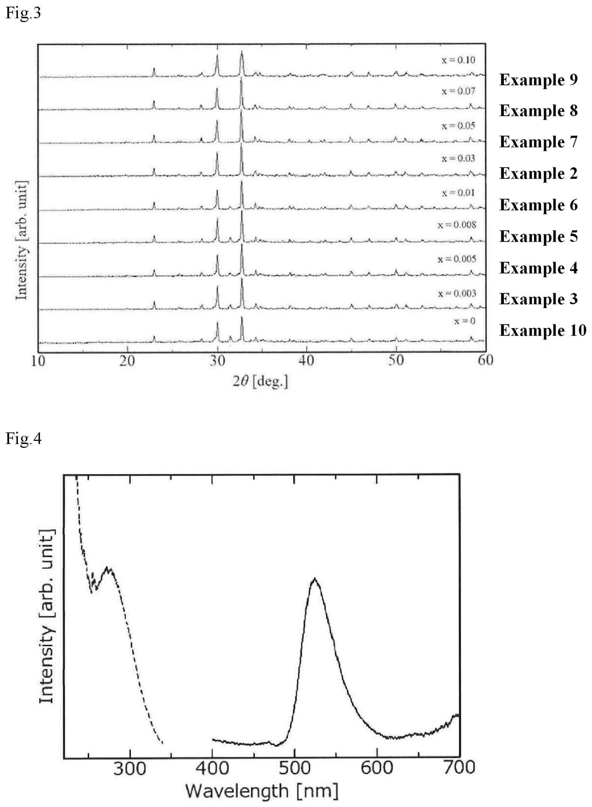

FIG. 3 illustrates powder X-ray diffraction patterns of crystal bodies of Examples 2 to 10. As is clear from FIG. 3, peaks similar to those for the crystal body of Example 1 were observed also for the crystal bodies of Examples 2 to 10.

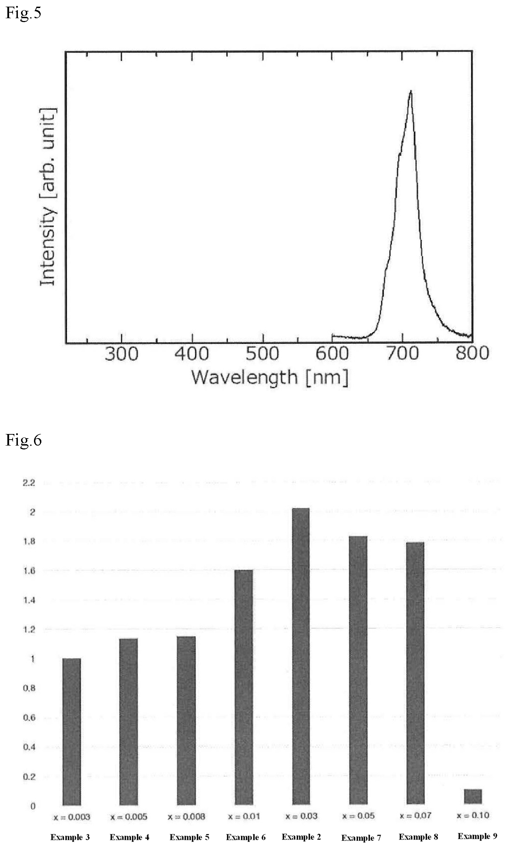

FIG. 4 and FIG. 5 illustrate measurement results of photoluminescence for the crystal body of Example 1. It can be seen from FIG. 4 that there is excitation in the ultraviolet region and there is green emission in the crystal body of Example 1. It can be seen from FIG. 5 that there is emission derived from Mn⁴⁺ around 700 nm in the crystal body of Example 1. Similar results were obtained also for Examples 2 to 10.

FIG. 6 illustrates the relation of emission intensity when the crystal bodies of Examples 2 to 9 are irradiated with ultraviolet light (365 nm) at a certain intensity. It can be seen from this figure that high emission intensity was obtained in the phosphors of Examples 2 to 8, in which particularly high emission intensity was obtained in the phosphor of Example 2, in which x in Formula (1) is 0.03.

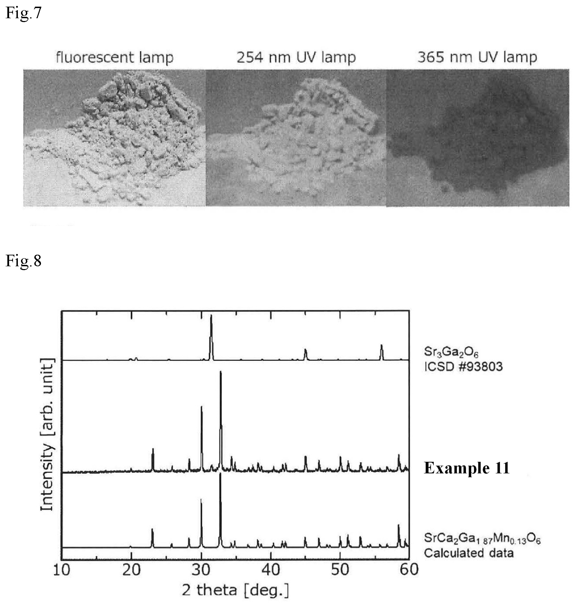

FIG. 7 illustrates photographs of the crystal body of Example 1 when irradiated with room light, when irradiated with ultraviolet light having a wavelength of 254 nm, and when irradiated with ultraviolet light having a wavelength of 365 nm.

It showed reddish gray under room light, showed green when irradiated with ultraviolet light having a wavelength of 254 nm, and showed red when irradiated with ultraviolet light having a wavelength of 365 nm. Similar results were obtained also for the crystal bodies of Examples 2 to 9.

FIG. 8 illustrates a powder X-ray diffraction pattern of the crystal body of Example 11.

In the X-ray diffraction pattern illustrated in FIG. 8, the ICSD (Inorganic Crystal Structure Database) data for Sr₃Ga₂O₆ and simulation results of an X-ray diffraction pattern for SrCa₂Ga_{1.87}Mn_{0.13}O₆ are also illustrated for reference.

FIG. 9 illustrates measurement results of photoluminescence for the crystal body of Example 11. It can be seen from FIG. 9 that there is excitation in the ultraviolet region and there is emission in the near-infrared region in the crystal body of Example 11.

Crystal bodies were produced in the same manner as in each of the examples except that some of the elements constituting the oxide matrix (SrCa₂Ga₂O₆) of each of the examples were substituted by elements other than Mn and Cr, more specifically, Bi, Pr, Sm, Eu, Tb, and Tm. These were evaluated in the same manner as above, and the crystal body containing Bi showed white under room light, showed blue long afterglow when irradiated with ultraviolet light having a wavelength of 254 nm, and showed yellow long afterglow when irradiated with ultraviolet light having a wavelength of 365 nm; the crystal body containing Pr showed yellow under room light, and showed yellow long afterglow or blue long afterglow when irradiated with ultraviolet light having a wavelength of 254 nm; the crystal body containing Sm showed yellow or white under room light, showed red or blue when irradiated with ultraviolet light having a wavelength of 254 nm, and showed red when irradiated with ultraviolet light having a wavelength of 365 nm; the crystal body containing Eu showed yellow or white under room light, showed red when irradiated with ultraviolet light having a wavelength of 254 nm, and showed red when irradiated with ultraviolet light having a wavelength of 365 nm; the crystal body containing Tb showed yellow under room light, and showed green long afterglow when irradiated with ultraviolet light having a wavelength of 254 nm; and the crystal body containing Tm showed yellow or white under room light, and showed blue long afterglow when irradiated with ultraviolet light having a wavelength of 254 nm.

Crystal bodies were produced in the same manner as in each of the examples except that the treatment temperature in the heat treatment step was changed in various ways within a range of 1,000°C or higher and 1,600°C or lower and the treatment time in the heat treatment step was changed in various ways within a range of 3 hours or more and 10 hours or less, and these were evaluated in the same manner as above to obtain results similar to those of the corresponding example.

### (Example 12)

First, BaCO₃ powder as a Ba source, SrCO₃ powder as a Sr source, CaCO₃ powder as a Ca source, Ga₂O₃ powder as a Ga source, and MnO₂ powder as a Mn source were prepared, and weighed so as to give a ratio Ba:Sr:Ca:Ga:Mn of 1.00:2.00:6.00:5.76:0.24 in terms of molar ratio.

Next, the above raw materials were mixed using an agate mortar to obtain a raw material mixture. Here, the mixture was wet-mixed using acetone as a solvent.

Next, the above raw material mixture was heated to 1,000°C in air, held at 1,000°C for 4 hours, then taken out once, ground in an agate mortar, then heated to 1,200°C, and held at 1,200°C for 6 hours to obtain powder with a composition represented by BaSr₂Ca₆(Ga_{0.96}Mn_{0.04})₆O₁₈.

### (Examples 13 to 18)

Crystal bodies were produced in the same manner as in Example 12 above except that the amounts of the Ba source, the Sr source, the Ca source, the Ga source, and the Mn source used were changed.

Table 1 lists the average particle sizes of the crystal bodies of Examples 12 to 18. The average particle size was measured by SEM measurement under the following procedure.

### <Measurement of Average Particle Size>

A picture of particles was taken using a scanning electron microscope (SEM: JSM-7900F, manufactured by JEOL Ltd.) at an acceleration voltage of 8 kV, 100 particles were arbitrarily selected in the obtained SEM image, and the short diameters of the particles were measured, and their average was calculated to be the average particle size. For image analysis, WinROOF, image analysis and measurement software, was used.

The crystal body obtained in Example 13 was powder with a composition represented by BaSr₂Ca₆(Ga_{0.99}Mn_{0.01})₆O₁₈, the crystal body obtained in Example 14 was powder with a composition represented by BaSr₂Ca₆(Ga_{0.98}Mn_{0.02})₆O₁₈, the crystal body obtained in Example 15 was powder with a composition represented by BaSr₂Ca₆(Ga_{0.97}Mn_{0.03})₆O₁₈, the crystal body obtained in Example 16 was powder with a composition represented by BaSr₂Ca₆(Ga_{0.95}Mn_{0.05})₆O₁₈, the crystal body obtained in Example 17 was powder with a composition represented by BaSr₂Ca₆(Ga_{0.94}Mn_{0.06})₆O₁₈, and the crystal body obtained in Example 18 was powder with a composition represented by BaSr₂Ca₆(Ga_{0.93}Mn_{0.07})₆O₁₈.

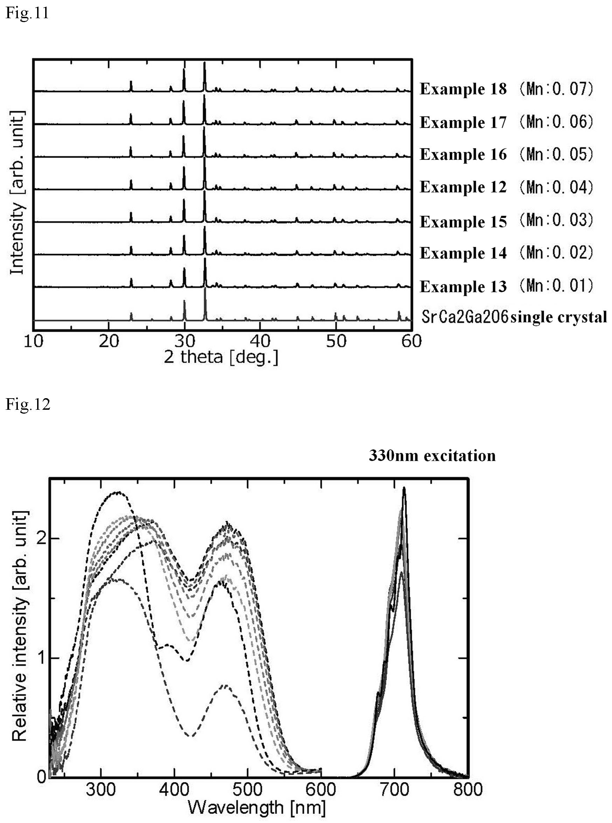

FIG. 11 illustrates X-ray diffraction patterns of the crystal bodies of Examples 12 to 18.

In the X-ray diffraction patterns illustrated in FIG. 11, the data of a single crystal X-ray diffraction pattern of Sr₃Ga₂O₆ is also illustrated for reference. Similar peaks were observed in the crystal bodies of Examples 12 to 18.

FIG. 12 illustrates measurement results of photoluminescence for the crystal bodies of Examples 12 to 18. As a comparative example, Ca₁₄Al₁₀Zn₆O₃₅:Mn⁴⁺ was also similarly measured. Table 1 lists the peak top intensity of an absorption peak around 715 nm, the peak top intensity of an absorption peak near 350 nm, and the peak top intensity of an emission peak around 460 nm. It can be seen from FIG. 12 and Table 1 that in the crystal bodies of Examples 12 to 18, particularly high emission intensity was obtained in the phosphor of Example 12, in which x in Formula (2) is 0.04. Each intensity is described as relative intensity when commercially available YAG is excited at 450 nm and the highest peak in the emission spectrum from 470 to 800 nm is set to 1.

**[Table 1]**

| | Average particle size (µm) | Emission intensity (-) | | Excitation intensity (-) | |
|---|---|---|---|---|---|
| | | Around 715 nm | | Around 350 nm | Around 460 nm |
| | | Incident 350 nm | Incident 460 nm | Incident 715 nm | |
| Example 12 | 4.3 | 2.2 | 2.2 | 2.2 | 2.1 |
| Example 13 | 4.2 | 1.7 | 0.5 | 1.6 | 0.7 |
| Example 14 | 5.1 | 2.3 | 1.6 | 2.2 | 1.6 |
| Example 15 | 4.9 | 2.2 | 2.0 | 2.2 | 1.8 |
| Example 16 | 5.0 | 2.1 | 2.1 | 2.1 | 2.0 |
| Example 17 | 4.5 | 2.2 | 2.2 | 2.1 | 2.1 |
| Example 18 | 4.2 | 1.9 | 2.0 | 2.0 | 2.0 |
| CZA | 5.0 | 2.4 | 1.6 | 2.4 | 1.6 |

In the table, CZA is Ca₁₄Al₁₀Zn₆O₃₅:Mn⁴⁺. Around 350 nm is the peak top absorption intensity of an absorption peak around 330 nm, around 460 nm is the peak top absorption intensity of an absorption peak around 450 nm, and around 715 nm is the peak top emission intensity of an emission peak around 715 nm.

### (Example 19)

The crystal body obtained in Example 15 in an amount of 120 g was dispersed in 250 mL of ethanol. Next, 1 g of 2-(methacryloyloxy)ethyl phosphate was added to the dispersion liquid. Next, the dispersion liquid was placed in a 500 mL round-bottom flask equipped with stirring blades, and mechanically stirred at a rotational speed of 400 rpm at 40°C for 3 hours. Next, 10 mg of azobisisobutyronitrile (AIBN) was dissolved in (100) mL of ethanol, and added dropwise to the dispersion liquid. The reaction solution was then heated to 75°C, and continued to be stirred at a rotational speed of 800 rpm for 2 hours. After a lapse of 2 hours, heating was stopped, and the mixture was cooled to room temperature with stirring. After cooling to room temperature, stirring was stopped, and the supernatant liquid was removed. The resulting fluorescent material was ultrasonically washed three times with 300 mL of ethanol and dried to obtain a light transmissive resin-coated fluorescent material in which the surface of the crystal body was coated with a light transmissive resin.

### (Example 20)

The light transmissive resin-coated fluorescent material obtained in Example 15 was dispersed in water so as to give a solid content concentration of 1.0% by mass to obtain a dispersion liquid.

### (Comparative Example 1)

Silica particles with an average particle size of 20 µm were dispersed in water so as to give a solid content concentration of 1.0% by mass to obtain a dispersion liquid.

Experiments on plant growth promotion were conducted using Sunny Lettuce (red leaf lettuce). The experimental procedure is as follows.

Sunny Lettuce seeds were placed on a sponge in a hydroponic system (manufactured by UING) equipped with white LEDs installed, and the dispersion liquid of Example 20 was sprayed 10 times on eight young seedlings 7 days after sowing. Then, the dispersion liquid was similarly sprayed on the eight seedlings 10 times each also on the 14th day, and the seedlings were harvested 21 days after sowing. The same operation was performed for the dispersion liquid of Comparative Example 1, and the seedlings were harvested 21 days after sowing.

Next, the fresh weight immediately after harvesting was measured. The fresh weight when sprayed with the light transmissive resin-coated fluorescent material obtained in Example 19 was 6.9 g, while the fresh weight when sprayed with the silica fine particles of Comparative Example 1 was 6.0 g, and the light transmissive resin-coated fluorescent material obtained in Example 19 has been found to increase in fresh weight by 15% by mass or more compared to the silica fine particles of Comparative Example 1.

### INDUSTRIAL APPLICABILITY

The crystal body of the present invention is composed of relatively inexpensive and stably available components and can be used as a phosphor having excellent characteristics. Therefore, the crystal body of the present invention has industrial applicability.

In addition, the phosphor of the present invention, and the fluorescent material and the resin sheet of the present invention are suitably used in technical fields in which red emission by wavelength conversion is required, especially in the technical field of plant growth promoting materials for agriculture.

## Claims

1. A crystal body comprising an oxide matrix composed of SrCa₂Ga₂O₆.

2. The crystal body according to claim 1, wherein part of Ga constituting the oxide matrix is substituted by another element.

3. The crystal body according to claim 2, wherein the other element is one or more selected from the group consisting of Mn, Cr, Fe, Ti, Bi, and rare earth elements.

4. The crystal body according to claim 2, wherein a substitution ratio of the Ga by the other element is 0.10 or less in terms of molar ratio.

5. The crystal body according to claim 2, wherein the crystal body is represented by Formula (1) below:
SrCa₂(Ga₍₁₋ₓ₎Mₓ)₂O₆ (1)
in Formula (1), M is one or more selected from the group consisting of Mn, Cr, Fe, Ti, Bi, and rare earth elements; and the relation 0 < x ≤ 0.10 is satisfied.

6. A crystal body comprising an oxide matrix composed of BaSr₂Ca₆Ga₆O₁₈.

7. The crystal body according to claim 6, wherein part of Ga constituting the oxide matrix is substituted by another element.

8. The crystal body according to claim 7, wherein the other element substituting the Ga is one or more selected from the group consisting of Mn, Cr, Fe, Ti, Bi, and rare earth elements.

9. The crystal body according to claim 7, wherein a substitution ratio of the Ga by the other element is 0.10 or less in terms of molar ratio.

10. The crystal body according to claim 7, wherein the crystal body is represented by Formula (2) below:
BaSr₂Ca₆(Ga₍₁₋ₓ₎Mₓ)₆O₁₈ (2)
in Formula (2), M is one or more selected from the group consisting of Mn, Cr, Fe, Ti, Bi, and rare earth elements; and the relation 0 < x ≤ 0.10 is satisfied.

11. A phosphor comprising the crystal body according to claim 3 or 8.

12. A fluorescent material comprising the phosphor according to claim 11 surface-coated with a light transmissive resin.

13. A resin sheet comprising a light transmissive resin base material, and comprising the phosphor according to claim 11.
